# EUROPÄISCHE PATENTANMELDUNG

(11) **EP 2 083 445 A1**
(43) Veröffentlichungstag der Anmeldung: **29.07.2009**
(21) Anmeldenummer: 08021180.8
(22) Anmeldetag: 05.12.2008
(51) Int. Cl.: H01L 27/142

(54) **Verfahren zur Herstellung eines photovoltaischen Moduls**

(30) Priorität: 26.01.2008 DE 102008006166
(71) Anmelder: SCHOTT Solar GmbH, 63755 Alzenau (DE)
(72) Erfinder: Lechner, Peter, 85591 Vaterstetten (DE); Psyk, Walter, 81371 München (DE)
(74) Vertreter: Haft, von Puttkamer, Berngruber

(57) **Zusammenfassung**

Zur Herstellung eines photovoltaischen Moduls (1) werden zur Bildung serienverschalteter Zellen (C₁, C₂, ... Cₙ, Cₙ₊₁) die Frontelektrodenschicht (3), die Halbleiterschicht (4) und die Rückelektrodenschicht (5) durch Trennlinien (6, 7, 8) mit einem Laser (14), der eine infrarote Strahlung emittiert, strukturiert. Bei der Strukturierung der Halbleiterschicht (4) und der Rückelektrodenschicht (5) wird die Leistung des Lasers (14) so herabgesetzt, dass die Frontelektrodenschicht (3) nicht beschädigt wird.

## Beschreibung

Die Erfindung bezieht sich auf ein Verfahren zur Herstellung eines photovoltaischen Moduls nach dem Oberbegriff des Anspruchs 1.

Bei der Herstellung eines photovoltaischen Moduls werden auf einem transparenten, elektrisch isolierenden Substrat, beispielsweise einer Glasscheibe, drei Funktionsschichten, nämlich eine transparente Frontelektrodenschicht, eine Halbleiterdünnschicht und eine Rückelektrodenschicht großflächig abgeschieden.

Um aus diesen monolithischen Schichten serienverschaltete Zellen zu bilden, werden die Schichten z. B. mit einem Laser, mechanische Verfahren oder auf chemischem Wege durch Trennlinien strukturiert.

Zur Strukturierung der Frontelektrodenschicht, die beispielsweise aus einem transparentem, elektrisch leitfähigen Metalloxid, beispielsweise Zinnoxid, besteht, wird üblicherweise die Lasertechnik verwendet. Der verwendete Laser ist typischerweise ein Neodym dotierter Yttrium-Aluminium-Granat (Nd:YAG)-Festkörperlaser oder Yttrium-Vanadat (Nd:YVO₄)-Festkörperlaser, der eine infrarote Strahlung mit einer Wellenlänge von 1064 nm emittiert. Bei dieser Wellenlänge weist die transparente Zinnoxid-Frontelektrodenschicht eine optische Absorption von mehreren Prozent auf.

Die Strukturierung der Halbleiterschicht, beispielsweise eine Silizium-Dünnschicht, erfolgt ebenfalls typischerweise mit Lasertechnik. Dabei wird ein frequenzverdoppelter Nd: YAG- oder Nd:YVO₄-Festkörperlaser verwendet, der damit ein Laserlicht mit einer Wellenlänge von 532 nm im sichtbaren Bereich emittiert. Bei dieser Wellenlänge besitzt die Silizium-Dünnschicht im Vergleich zur transparenten Frontelektrodenschicht ein hohes optisches Absorptionsvermögen. Dadurch ist ein selektiver Abtrag der Halbleiterschicht ohne Beeinträchtigung der Frontelektrodenschicht möglich.

Für die Strukturierung der Rückelektrodenschicht werden mechanische Verfahren, wie die "Lift Off"-Technik, bei der auf der Halbleiterschicht in den Bereichen, an denen die Rückelektrodenschicht mit Trennlinien versehen werden soll, eine haftende Paste aufgebracht wird, mit der die Rückelektrodenschicht in diesen Bereichen durch Abziehen entfernt wird, aber auch Laserverfahren mit einem frequenzverdoppeltem Nd:YVO₄- oder Nd:YAG-Laser mit einer Wellenlänge von 532 nm verwendet.

Wenn die Trennlinien in der Halbleiterschicht mit dem Laser gebildet worden sind, wird die darunter liegende Frontelektrodenschicht freigelegt. Bei der anschließenden Abscheidung der Rückelektrodenschicht wird die Rückelektrodenschicht dadurch mit der Frontelektrodenschicht kontaktiert, wodurch die Zellen des photovoltaischen Moduls serienverschaltet werden.

Für die Herstellung des photovoltaischen Moduls werden mehrere kostspielige Anlagen benötigt. Die Anlage zur Halbleiterbeschichtung ist dabei meist mit den höchsten Investitionskosten verbunden. Daneben stellen die Laseranlagen wichtige Kostenfaktoren dar.

Die Kapazität der Halbleiterbeschichtungsanlage und die Kapazität der Laseranlagen sind meist unterschiedlich. Als kostspieligste Anlage wird dabei bei der industriellen Produktion von photovoltaischen Modulen die Halbleiterbeschichtungsanlage im allgemeinen zu 100 % ausgelastet.

Wenn mit der Halbleiterbeschichtungsanlage beispielsweise maximal eine Beschichtung von 210000 Modulen pro Jahr durchgeführt werden kann, jede Laseranlage mit einer Wellenlänge von 1064 nm bzw. 532 nm aber z. B. nur für maximal 90000 Module pro Jahr ausgelegt ist, hat dies zur Folge, dass, weil die Kapazität von zwei Laseranlagen pro genannter Wellenlänge und Prozess für die Frontelektrode und der Rückelektrode mit 180000 nicht ausreicht, insgesamt sechs kostspielige Laseranlagen angeschafft werden müssen. Die Zahl der Laseranlagen führt daher bei der industriellen Herstellung von photovoltaischen Modulen zu einem erheblichen Kostenproblem.

Aufgabe der Erfindung ist es daher, die Kosten für die industrielle Herstellung photovoltaischer Module deutlich herabzusetzen.

Dies wird erfindungsgemäß dadurch erreicht, dass der Laser, der zur Strukturierung der Frontelektrodenschicht verwendet wird, auch zur Strukturierung der Rückelektrodenschicht eingesetzt wird.

Wie festgestellt werden konnte, kann man nämlich die Rückelektrodenschicht mit der darunter liegenden Halbleiterschicht, beispielsweise eine Siliziumschicht auch dann mit einem Laser entfernen, wenn der Laser eine Infrarotstrahlung emittiert, die zwar von der transparenten Frontelektrodenschicht absorbiert wird, nicht aber von der Halbleiterschicht.

Die Absorption der Laserstrahlung durch die Frontelektrodenschicht hat nämlich zur Folge, dass die Frontelektrodenschicht durch die Laserstrahlung so aufgeheizt wird, dass nicht nur die darüber liegende Halbleiterschicht thermisch entfernt wird und damit eine Strukturierung der Halbleiterschicht durch Trennlinien durchgeführt werden kann, sondern, wenn die Halbleiterschicht mit der Rückelektrodenschicht beschichtet wird, die Halbleiterschicht zusammen mit der Rückelektrodenschicht thermisch entfernt wird und damit auch eine Strukturierung der Rückelektrodenschicht durch Trennlinien möglich ist. Unter Umständen ist noch eine Strahlaufweitung und eine Blende oder ein optisches Strahlformimsystem, z.B. refraktive oder diffraktive Optik, die dem Laserstrahl ein Tophead-Profil gibt, für den Prozess notwendig.

Zwar werden damit bei der Strukturierung der Rückelektrodenschicht zusätzliche Trennlinien in der Halbleiterschicht gebildet. Diese zusätzlichen Trennlinien in der Halbleiterschicht wirken sich jedoch auf die Leistung des photovoltaischen Moduls praktisch nicht aus.

Wesentlich ist allerdings, dass, wenn der Laser zur Strukturierung der Rückelektrodenschicht und der darunter liegenden Halbleiterschicht eingesetzt wird, seine Leistung so herabgesetzt wird, dass die Frontelektrodenschicht idealer Weise nicht beschädigt, also verletzt oder in anderer Weise beeinträchtigt wird. Das heißt, während der Laser zur Strukturierung der Frontelektrodenschicht gegebenenfalls mit seiner vollen, jedenfalls einer hohen Leistung eingesetzt wird, wird bei der Strukturierung der Rückelektrodenschicht mit der darunter liegenden Halbleiterschicht eine relativ geringere Laserleistung eingestellt.

Da erfindungsgemäß ein- und dieselbe Laseranlage sowohl zur Strukturierung der Frontelektrodenschicht, wie zur Strukturierung der Rückelektrodenschicht mit der darunter liegenden Halbleiterschicht einsetzbar ist, kann erfindungsgemäß die Anzahl der Laseranlagen bei der industriellen Herstellung photovoltaischer Module herabgesetzt werden. Das heißt, wenn gemäß dem eingangs geschilderten Beispiel die Halbleiterbeschichtungsanlage eine maximale Kapazität für 210000 Module pro Jahr aufweist, reichen fünf Laser mit einer maximalen Kapazität von jeweils 90000 Modulen pro Jahr aus, sodass gegenüber dem Stand der Technik eine Laseranlage eingespart werden kann.

Wenn nun auch die Laserstrukturierung der Halbleiterschicht mit der Wellenlänge 1064nm mit dem Nd:YV04- oder ND:YAG-Festkörperlaser durchführt, die nach Stand der Technik mit der Wellenlänge 532nm erfolgt und diese Laser ebenfalls eine maximale Kapazität von 90000 Modulen pro Jahr haben, können gegenüber dem Stand der Technik zwei Laseranlagen eingespart werden. Somit sind dann sieben Laseranlagen für die Strukturierung von Frontelektroden-, Halbleiter- und Rückelektrodenschicht notwendig. Nach Stand der Technik wären in dem Beispiel neun Anlagen notwendig.

Ebenso wird erfindungsgemäß durch die Redundanz der Laserstrukturierungsprozesse eine wesentlich größere Flexibilität und Gesamt-Anlagenverfügbarkeit in der Produktion gewährleistet. Bei Wartung oder Störung einer Laserstrukturierungsanlage (beispielsweise für eine Frontelektrodenschicht) können aufgrund der Redundanz auch Laserstrukturierungsanlagen für die Rückelektrodenschicht (erweitert auch für die Halbleiterschicht) die Prozesse für die Strukturierung der Frontelektrodenschicht übernehmen bzw. auch zusätzlich für die Strukturierung der Halbleiterschicht übernehmen.

Die Frontelektrodenschicht kann aus einem elektrisch leitfähigem Metalloxid, beispielsweise Zinnoxid (SnO₂), insbesondere Fluor dotiertem Zinnoxid oder einem anderen Material bestehen. Wesentlich ist nur, dass es transparent und elektrisch leitfähig ist, zumindest einen Teil, vorzugsweise mindestens 0,5 %, insbesondere mindestens 2 % der emittierten infraroten Strahlung des Lasers absorbiert und thermisch stabiler ist als die Rückelektrodenschicht mit der darunter liegenden Halbleiterschicht.

Damit werden mit dem Laser vorzugsweise bei seiner vollen Leistung die Trennlinien zur Strukturierung der Frontelektrodenschicht erzeugt, die zuvor auf dem transparenten Substrat, beispielsweise einer Glasscheibe, z. B. durch chemische Dampfabscheidung aufgebracht worden ist.

Auf der strukturierten Frontelektrodenschicht wird anschließend beispielsweise durch chemische Dampfabscheidung die Halbleiterschicht aufgetragen.

Die Halbleiterschicht kann aus Silizium, beispielsweise amorphem, nano-, mikro- oder polykristallinem Silizium bestehen, aber auch aus an deren Halbleitern, beispielsweise Cadmium-Tellur.

Die Rückelektrodenschicht ist vorzugsweise eine Metallschicht, beispielsweise aus Aluminium, Kupfer, Silber oder dergleichen. Sie kann durch Sputtern aufgebracht werden. Auch kann zwischen der Metallschicht und der Halbleiterschicht eine Zwischenschicht aufgebracht werden, gegebenenfalls auch durch Sputtern, die beispielsweise aus einem dotierten Halbleiter, wie Indiumoxid, oder Aluminium dotiertem Zinkoxid besteht und die verhindert, dass Metallatome aus der Metallschicht in die Halbleiterschicht des Moduls diffundieren.

Der erfindungsgemäß eingesetzte Laser emittiert eine Infrarotstrahlung, also eine Strahlung mit einer Wellenlänge von mindestens 800 nm, vorzugsweise 1000 nm und mehr, insbesondere wird ein im nahen Infrarotbereich emittierender Festkörperlaser verwendet. Der Festkörperlaser kann auch ein Faserlaser oder ein Scheibenlaser sein.

Vorzugsweise ist der Festkörperlaser ein Nd:YVO₄-Laser, d. h. er weist als Wirtskristall Yttrium-Vanadat auf. Statt dessen kann der Wirtskristall beispielsweise auch Yttrium-Aluminium-Granat (YAG) sein. Zur Dotierung wird vorzugsweise Neodym verwendet, also ein Festkörperlaser mit einer Wellenlänge von 1064 nm eingesetzt. Gegebenenfalls kann auch Erbium, Ytterbium oder ein anderes Element zur Dotierung des Lasers verwendet werden. Ein Neodym dotierter Yttrium-Vanadat-Laser (Nd:YVO₄-Laser) oder Neodym dotierter YAG-Laser (Nd:YAG-Laser) wird besonders bevorzugt.

Zur Strukturierung der Halbleiterschicht kann der Laserstrahl durch das transparente Substrat hindurch auf die Frontelektrodenschicht und Halbleiterschicht an der Stelle fokussiert werden, an der die Trennlinien in der Halbleiterschicht erzeugt werden sollen. Statt dessen kann die Strukturierung der Halbleiterschicht auch so durchgeführt werden, dass der Laserstrahl von der anderen Seite, also direkt auf die Halbleiterschicht gerichtet wird.

Dabei kann in der Halbleiterschicht eine beispielsweise 10 bis 100 µm breite Trennlinie erzeugt werden, durch die die darunter liegende Frontelektrodenschicht freigelegt wird. Anschließend wird die Halbleiterschicht beispielsweise durch Sputtern mit der Rückelektrodenschicht beschichtet.

Zur Strukturierung der Rückelektrodenschicht wird der Laserstrahl durch das transparente Substrat hindurch auf die Funktionsschichten an der Stelle fokussiert, an der die Trennlinien in der Rückelektrodenschicht erzeugt werden sollen. Dadurch kann in der Rückelektrodenschicht eine beispielsweise 10 bis 100 µm breite Trennlinie erzeugt werden, durch die die für die integrierte Serienverschaltung notwendige elektrische Trennung der Zellen des photovoltaischen Moduls erzielt wird. Als Nebeneffekt, aber nicht notwendigerweise, wird bei diesem Prozess auch die Halbleiterdünnschicht vollständig oder teilweise entfernt.

Die Strukturierung der Rückelektrodenschicht erfolgt vorzugsweise gepulst, also insbesondere im Gütegeschalteten Betrieb ("Q-Switch-Betrieb"), um in der Rückelektrodenschicht Trennlinien mit scharfen Kanten zu erhalten. Dabei wird der gepulste Betrieb in Kombination mit einer Strahlaufweitung und einer Blende im Laserstrahl durchgeführt, um z. B. durch ein "Top Head"-förmiges Strahlprofil nur das Zentrum des Laserstrahls einwirken zu lassen. Die optischen Einrichtungen, beispielsweise zur Strahlaufweitung und die Blende oder ein optisches Strahlumformsystem (z.B. refraktive oder diffraktive Optik) sind vorzugsweise aus den Laserstrahl auschwenkbar oder in anderer Weise herausbewegbar.

Erfindungsgemäß wird die Energie des Lasers von der Frontelektrodenschicht absorbiert und durch Wärmeleitung auf die Halbleiterdünnschicht mit der darüber liegenden Rückelektrodenschicht übertragen.

Bei der Laserstrahl-Einkopplung durch das transparente Substrat, also z. B. die Glasscheibe in die Frontelektrodenschicht, um eine Trennlinie in der Rückelektrodenschicht zu erzeugen, wird die Halbleiterschicht zusammen mit der Rückelektrodenschicht abgesprengt, also thermisch-mechanisch entfernt.

Nachstehend ist die Erfindung anhand der beigefügten Zeichnung beispielhaft näher erläutert. Darin zeigen jeweils schematisch im Längsschnitt
Figur 1 eine photovoltaisches Modul; und
Figur 2a bis 2f die einzelnen Schritte zur Herstellung des photovoltaischen Moduls nach Figur 1.

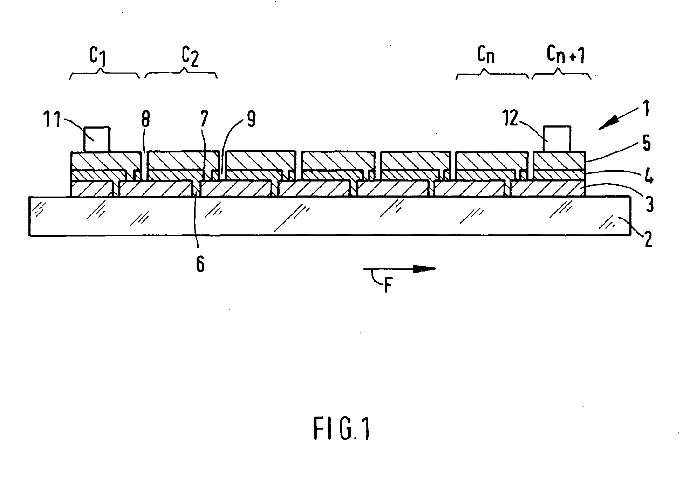

Gemäß Figur 1 weist das photovoltaische Modul 1 ein transparentes Substrat 2, z. B. eine Glasscheibe, auf, auf der drei Funktionsschichten, nämlich eine transparente Frontelektrodenschicht 3, eine Halbleiterdünnschicht 4 und eine Rückelektrodenschicht 5 aufeinander abgeschieden sind.

Das Modul 1 besteht aus einzelnen streifenförmigen Zellen C₁, C₂, ... Cₙ, Cₙ₊₁, die serienverschaltet sind und senkrecht zur Stromflussrichtung F verlaufen. Dazu ist die Frontelektrodenschicht 3 durch Trennlinien 6, die Halbleiterschicht 4 durch Trennlinien 7 und die Rückelektrodenschicht 5 durch Trennlinien 8 unterbrochen, und damit strukturiert.

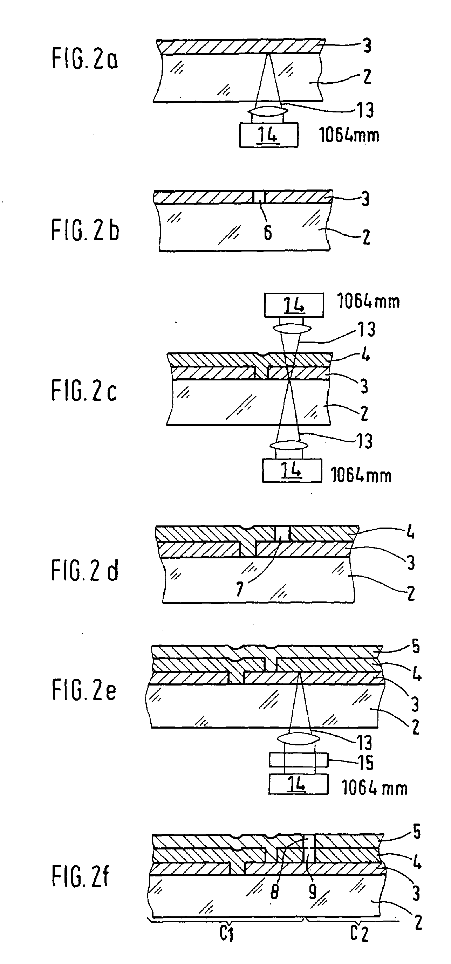

Wie bereits vorstehend und anhand der Figuren 2e und 2f nachstehend nochmals erläutert, entstehen bei Bildung der Trennlinien 8 in der Rückelektrodenschicht 5 auch in der Halbleiterschicht 4 dazu fluchtende weitere Trennlinien 9. Die Trennlinien 9 sind jedoch für die Funktion und Wirksamkeit des Moduls 1 ohne Bedeutung.

Gemäß Figur 1 kontaktiert die Rückelektrodenschicht 5 einer Zelle C₁, Cₙ damit durch die Trennlinie 7 in der Halbleiterschicht 4 die Frontelektrodenschicht 3 der benachbarten Zelle C₂, Cₙ₊₁, wodurch der Minuspol einer Zelle C₁, Cₙ mit dem Pluspol der benachbarten Zelle C₂, Cₙ₊₁ verbunden wird.

Der von dem photovoltaischen Modul erzeugte Strom wird durch die Kontakte 11, 12 an den äußersten Zellen C₁, Cₙ₊₁ abgenommen. An der Rückseite des Moduls 1 mit den Kontakten 11, 12 ist noch ein nicht dargestellter Rückseitenschutz aus Kunststoff oder einem anderen elektrisch isolierendem Material vorgesehen.

In Figur 2f ist am Beispiel der Zellen C₁ und C₂ nach Figur 1 die Serienverschaltung zweier benachbarter Zellen dargestellt. Gemäß Figur 2a bis 2f werden die serienverschalteten Zellen C₁ und C₂ wie folgt hergestellt:

Ausgehend von einem mit der Frontelektrodenschicht 3 beschichteten Glassubstrat 2 werden mit dem fokussiertem Laserstrahl 13 des Lasers 14, der eine Infrarotstrahlung emittiert, beispielsweise einem Nd:YVO₄- oder Nd:YAG-Laser mit einer Wellenlänge von 1064 nm die Trennlinien 6 zur Strukturierung der beispielsweise aus Zinnoxid bestehenden Frontelektrodenschicht 3 erzeugt, und zwar durch Schmelzen bzw. Verdampfen der Frontelektrodenschicht 3, da die Frontelektrodenschicht 3 die Laserstrahlung dieser Wellenlänge absorbiert.

Nach Figur 2a ist der Laserstrahl 13 durch das Glassubstrat 3 hindurch auf die Frontelektrodenschicht 3 gerichtet. Die Strukturierung der Frontelektrodenschicht 3 kann jedoch auch von der anderen Seite, also mit direkt auf die Frontelektrodenschicht 3 gerichtetem Laserstrahl, durchgeführt werden.

Auf die so gebildete, strukturierte Frontelektrodenschicht 3 gemäß Figur 2b wird die Halbleiterdünnschicht 4, die beispielsweise aus Silizium besteht, z. B. durch chemische Dampfabscheidung abgeschieden.

Wie in Figur 2c dargestellt, wird zur Strukturierung der Halbleiterschicht 4 der die gleiche Infrarotstrahlung emittierende Laser 14, also beispielsweise ein Nd:YVO₄- oder Nd:YAG-Laser mit einer Wellenlänge von 1064 nm verwendet, der sowohl von der Halbleiterschichtseite her, wie in Figur 2c durch den über der Halbleiterschicht 4 angeordneten Laser 14 veranschaulicht, oder durch das Glassubstrat 2, wie in Figur 2c durch den unter dem Glassubstrat 2 angeordneten Laser 13 veranschaulicht, auf die beiden Schichten 3 und 4 in dem Bereich gerichtet, also fokussiert wird, in dem die Trennlinien 7 zur Strukturierung der Halbleiterschicht 4 gebildet werden sollen.

Zwar absorbiert die Halbleiterschicht 4 dabei keine bzw. sehr gering die Strahlung dieser Wellenlänge, es erfolgt jedoch eine Absorption der Laserstrahlung 13 des Lasers 14 durch die darunter liegende Frontelektrodenschicht 3, die sich dadurch thermisch so aufheizt, dass die thermisch weniger stabile Halbleiterschicht 4 unter Bildung der Trennlinien 7 abgesprengt, jedenfalls beseitigt wird, und damit die Frontelektrodenschicht 3 im Bereich der Trennlinien 7 freigelegt wird. Um die Frontelektrodenschicht 3 idealer Weise nicht zu beschädigen, wird dabei die Leistung des Lasers 14 entsprechend reduziert.

Auf das mit der strukturierten Frontelektrodenschicht 3 und der strukturierten Halbleiterdünnschicht 4 beschichtete Glassubstrat 2 gemäß Figur 2d wird anschließend die z. B. aus Metall bestehende Rückelektrodenschicht 5 beispielsweise durch Sputtern abgeschieden.

Zur Strukturierung der Rückelektrodenschicht 5 wird gemäß Figur 2e der die gleiche IR-Strahlung emittierende Laser 14, also z. B. der Nd:YVO₄- oder Nd:YAG-Laser mit einer Wellenlänge von 1064 nm, gegebenenfalls mit einer einschwenkbaren optischen Einrichtung 15 (z.B. Aufweitung, Blende, refraktive/diffraktive Optik)verwendet, der durch das Glassubstrat 2 hindurch auf die Schichten 3, 4, 5 in dem Bereich gerichtet, also fokussiert wird, in dem die Trennlinien 8 zur Strukturierung der Rückelektrodenschicht 5 gebildet werden sollen.

Die Halbleiterschicht 4 absorbiert dabei keine bzw. sehr gering Strahlung dieser Wellenlänge, es erfolgt jedoch eine Absorption der Laserstrahlung 13 des Lasers 14 durch die darunter liegende Frontelektrodenschicht 3, die sich dadurch thermisch so aufheizt, dass die thermisch weniger stabile Halbleiterschicht 4 unter Bildung der Trennlinien 7 abgesprengt, jedenfalls beseitigt wird, und damit die Frontelektrodenschicht 3 im Bereich der Trennlinien 7 freigelegt wird. Um die Frontelektrodenschicht 3 nicht zu beschädigen, wird dabei die Leistung des Lasers 14 entsprechend reduziert.

Zwar absorbiert die Rückelektrodenschicht 5 nur einen Teil dieser Wellenlänge und die Halbleiterschicht 4 keine bzw. sehr gering die Strahlung dieser Wellenlänge, es erfolgt jedoch eine Absorption der Laserstrahlung 13 des Lasers 14 durch die Frontelektrodenschicht 3 unter der Halbleiterschicht 4, die sich dadurch thermisch so ausheizt, dass die thermisch weniger stabile Halbleiterschicht 4 und die darüber liegende Rückelektrodenschicht 5 in diesem Bereich unter Bildung der Trennlinien 8 in der Rückelektrodenschicht 5 und der dazu fluchtenden weiteren Trennlinie 9 in der Halbleiterschicht 4 abgesprengt, jedenfalls beseitigt wird. Um die Frontelektrodenschicht 3 nicht zu beschädigen, wird dabei die Leistung des Lasers 14 entsprechend reduziert.

Zwar entstehen damit nach dem erfindungsgemäßen Verfahren in der Halbleiterschicht 4 die zusätzlichen Trennlinien 9. Sie führen jedoch zu keiner spürbaren Beeinträchtigung der Funktion und Leistung des photovoltaischen Moduls 1.

## Patentansprüche

1. Verfahren zur Herstellung eines photovoltaischen Moduls (1), bei dem auf einem transparenten Substrat (2) eine transparente Frontelektrodenschicht (3), eine Halbleiterschicht (4) und eine Rückelektrodenschicht (5) als Funktionsschichten abgeschieden wird, welche zur Bildung serienverschalteter Zellen (C₁, C₂, ... Cₙ, Cₙ₊₁) durch Trennlinien (6, 7, 8) strukturiert werden, wobei eine Laserstrukturierung der drei Funktionsschichten (3, 4, 5) durchgeführt und zur Laserstrukturierung der Frontelektrodenschicht (3) ein Laser (14) verwendet wird, der eine infrarote Strahlung emittiert, **dadurch gekennzeichnet, dass** der Laser (14), der zur Strukturierung der Frontelektrodenschicht (3) verwendet wird, auch zur Strukturierung der Rückelektrodenschicht (5) eingesetzt wird, wobei die Leistung des Lasers (14) bei der Strukturierung der Rückelektrodenschicht (5) so herabgesetzt wird, dass die Frontelektrodenschicht (3) nicht beschädigt wird.

2. Verfahren nach Anspruch 1, **dadurch gekennzeichnet, dass** der Laser (14), der zur Strukturierung der Frontelektrodenschicht (3) und zur Strukturierung der Rückelektrodenschicht (5) verwendet wird, auch zur Strukturierung der Halbleiterschicht (4) eingesetzt wird.

3. Verfahren nach Anspruch 1, **dadurch gekennzeichnet, dass** die Strukturierung mit einem Laser (14), der durch einem optoakustischen Schalter oder Güteschalter gepulst wird (QS-Betrieb) und mit einer optischen Einrichtung (15), bestehend aus Strahlaufweitung, einer Blende und/oder refraktiver bzw. diffraktiver Optik im Laserstrahl durchgeführt wird.

4. Verfahren nach Anspruch 3, **dadurch gekennzeichnet, dass** mit der optischen Einrichtung (15) ein "TopHead"-förmiges Strahlprofil erhältlich ist.

5. Verfahren nach Anspruch 3, **dadurch gekennzeichnet, dass** die optische Einrichtung (15) aus dem Laserstrahl (13) herausbewegbar ist.

6. Verfahren nach einem der vorstehenden Ansprüche, **dadurch gekennzeichnet, dass** der Laser (14) eine Wellenlänge aufweist, bei der die optische Absorption der Frontelektrodenschicht (3) mindestens 0,5 % beträgt.

7. Verfahren nach einem der vorstehenden Ansprüche, **dadurch gekennzeichnet, dass** ein Neodym dotierter Festkörperlaser mit einer Wellenlänge von 1064 nm verwendet wird.

8. Verfahren nach einem der vorstehenden Ansprüche, **dadurch gekennzeichnet, dass** ein Yttrium-Aluminium-Granat- oder ein Yttrium-Vanadat-Festkörperlaser verwendet wird.

9. Verfahren nach Anspruch 7 oder 8, **dadurch gekennzeichnet, dass** ein Neodym dotierter Yttrium-Aluminium-Granat-Laser oder ein Neodym dotierter Yttrium-Vanadat-Laser verwendet wird.

10. Verfahren nach einem der vorstehenden Ansprüche, **dadurch gekennzeichnet, dass** der Laserstrahl (13) zur Strukturierung der Rückelektrodenschicht (5) durch das transparente Substrat (2) auf die drei Funktionsschichten (3, 4, 5) gerichtet wird.
